**Europäisches Patentamt**

**European Patent Office**

**Office européen des brevets**

(11) Publication number: **0 243 844**
**A2**

(12) # EUROPEAN PATENT APPLICATION

(21) Application number: **87105801.2**

(22) Date of filing: **20.04.87**

(51) Int. Cl.³: **H 03 K 17/73**

(30) Priority: **22.04.86 US 854559**

(43) Date of publication of application:
**04.11.87 Bulletin 87/45**

(84) Designated Contracting States:
**DE FR GB IT**

(71) Applicant: **ALLEN-BRADLEY COMPANY, INC.**
**1201 South Second Street**
**Milwaukee Wisconsin 53204(US)**

(72) Inventor: **Wirth, William F.**
**N4768 Indian Point Road**
**Sullivan, Wisconsin 53178(US)**

(74) Representative: **Lippert, Hans, Dipl.-Ing. et al,**
**Reichel und Reichel Parkstrasse 13**
**D-6000 Frankfurt (Main) 1(DE)**

(54) **Method and circuit for gated turn-off of a thyristor.**

(57) A method for turning off higher anode currents in a GTO device (12-18) without the use of a snubber circuit and a gate inductor includes applying (by closing a switch ($S_2$) a reverse bias voltage ($V_3$) across the gate-cathode junction (12, 13) that is greater than the avalanche voltage, maintaining the reverse bias voltage ($V_3$) until the anode current (I) is substantially interrupted, and then removing (by opening switch $S_2$) the reverse bias voltage ($V_3$) in sufficient time to prevent undue heating within the thyristor (12-18). A circuit for carrying out the method is also disclosed.

FIG. 5

Croydon Printing Company Ltd.

METHOD AND CIRCUIT
FOR GATED TURN-OFF
OF A THYRISTOR

## Background of the Invention

1. Field of the Invention

The field of the invention is thyristor circuits, and more particularly, circuits including a gate turn-off (GTO) thyristor.

2. Background Art

Thyristors are 4-layer semiconductor devices in which layers of p-type and n-type material are alternated in a sandwich structure to form a p-n-p-n device, for example. The planar boundary regions where these layers contact one another are referred to as junctions, which serve as a point of reference when describing the movement of electrical charge carriers from one layer to another.

One type of thyristor is the silicon-controlled rectifier (SCR). In this type of device the second p-type layer is attached to a gate terminal. Positive charge carriers can be injected through the gate into the second p-type layer to turn the device on, provided that there is a positive voltage across the entire p-n-p-n sandwich. Once the device is turned on, however, it cannot be turned off through the gate. It must be turned off by removing the positive current through the entire p-n-p-n sandwich. In terms of a sinusoidal current wave with positive and negative half cycles, the current wave must pass through its zero point to turn off the device.

Another type of thyristor is the gate turn-off (GTO) type. This device can also take the form of a p-n-p-n sandwich, but it can be turned off by draining electrical current through the gate. The difference between the SCR and the GTO that allows this operation is a difference in the three-dimensional geometry of the layers of the two devices. The GTO is arranged so that the gate terminal covers a larger area and acts more uniformly on the density of current in the p-type and n-type layers.

The turn-off operation of GTO devices still presents a technical problem. As current is drained from the second p-type layer (as the device begins to turn off), there is a capacitive effect within the p-n-p-n sandwich. The voltage across the gate and an anode(+) contacting the first p-layer begins to rise and this tends to re-establish current in the region of the sandwich that is furthest from the gate.

In motor control applications, semiconductor devices must operate at substantial voltage and current ratings to control the phase signals supplied to the motor windings. These devices are turned on and off many times per second. GTO's have not found widespread application to motor control because the additional snubber circuitry required to turn off each GTO device (a group of GTO's being used to control one motor) presents problems of cost and packaging.

In GTO control circuitry, an inductor has been connected to the gate of the device to limit the rise of the reverse gate current during the turn-off event. This inductor has been suggested by the manufacturers of GTO devices, and has been considered essential to the control circuitry for GTO's.

In GTO control circuitry a snubber circuit has been connected across the p-n-p-n sandwich to prevent failure of GTO device during turn-off. This snubber circuit includes a

- 7 -

capacitor which tends to limit the rise of the anode-gate voltage as the device is turned off.

The use of snubber circuits creates certain additional requirements or constraints on the design of the GTO control circuit. As with the inductor, the snubber circuit adds to the cost and packaging requirements for the GTO device. Also, the capacitor in the snubber circuit must be discharged after each turn-off, which uses power. The snubber circuit also affects the timing requirements of the turn-off event and may provide undesirable interaction with bridge circuitry if the GTO were to be used in motor control circuits. Up to this time, these limitations were accepted in order to provide a circuit to limit the rise of anode-cathode voltage during the turn-off event. The result, however, was a GTO circuit that was not competitive in cost or performance with circuits using power transistors for motor control applications.

## Summary of the Invention

The invention is practiced in a method and circuit for turning off a gated turn-off (GTO) thyristor.

In the method of the invention, a reverse bias voltage that is greater than avalanche voltage is applied across the gate and cathode. This voltage is maintained until a capacitive effect across the anode and gate of the thyristor has subsided. The reverse bias voltage is then removed in sufficient time to prevent undue heating within the thyristor. This aspect of the invention increases the change in gate current with respect to time ($dI_G/dt$) by increasing applied voltage to a range not found in the prior art.

In a further aspect of the invention, the power supply circuit for applying the reverse bias voltage is connected to the gate of the thyristor through a circuit path that is free of inductive devices, which is in contrast to the typical gate circuit path in which an inductor is inserted to limit the change in gate current with respect to time - $(dI_G/dt)$.

The concept of the invention is to generate a much greater $(dI_G/dt)$ than was generated by the turn-off control circuits of the prior art. The change in gate current with respect to time $(dI_G/dt)$ is related to the reverse bias voltage (V) and the inductance $(L_G)$ in the gate circuit path as follows:

$$\frac{V}{L_G} = dI_G/dt$$

From this it can be seen that $dI_G/dt$ is maximized by maximizing reverse bias voltage (V) and minimizing the inductance $(L_G)$ in the gate circuit path.

Underlying the invention is the discovery that by maximizing $dI_G/dt$ over a short period of time, the gate-cathode junction will pass through a transient period in which it exhibits a junction recovery effect, before the occurrence of the capacitive effect involving the rise of anode-to-gate voltage relative to time $(dV_{AG}/dt)$. The recovery effect at the gate-cathode junction will cause the turn-off of the thyristor, provided that current is not first re-established by the rise of anode-to-gate voltage relative to time $(dV_{AG}/dt)$.

The turn-off of the GTO device according to the invention can be accomplished without the use of a snubber circuit to limit the rise of anode-to-gate voltage relative to time

- 5 -

$(dV_{AG}/dt)$. This turn-off can also be accomplished for 100% of the rated anode current for the GTO device.

The invention is practiced with a control circuit for turning the GTO device on and off. To turn off the GTO, the circuit includes means for applying a reverse bias voltage that is greater than an avalanche voltage across the gate and cathode. The circuit also includes means for maintaining the applied voltage until the anode current has been substantially interrupted. The circuit also includes means for removing the reverse bias voltage in sufficient time to prevent undue heating within the thyristor.

In a further aspect of the invention, the means for applying the reverse bias voltage is connected to the gate of the thyristor through a circuit path that is free of inductive devices.

One object of the invention is to improve the control of GTO devices for application to motor control circuitry.

Another object of the invention is to provide a GTO turn-off circuit that will remove the need for a snubber circuit. This will avoid the limitations accompanying snubber circuits such as increased cost and packaging requirements, lower power efficiency, timing constraints and undesireable interaction with bridge circuitry in motor control applications.

Another object of the invention is to turn off higher anode currents in GTO devices.

These and other objects and advantages of the invention will become apparent from the following description and from the drawings, which form a part hereof and which are referred to in the description. These disclose a preferred embodi-

-5-

ment--which is but one example of the invention. For the range of devices contemplated by the invention, reference is made to the claims which follow the description.

### Brief Description of the Drawings

Fig. 1 is a detail view of a portion of a gated turn-off (GTO) thyristor;

Fig. 2 is sectional view taken in the plane indicated by line 2--2 in Fig. 1;

Fig. 3 is one schematic diagram of a circuit of the prior art for turn-off of a GTO thyristor;

Fig. 4 is an equivalent schematic diagram for the circuit of Fig. 3;

Fig. 5 is one schematic diagram of a circuit for practicing the present invention;

Fig. 6 is an equivalent schematic diagram for the circuit of Fig. 5;

Fig. 7 is a plot of several waveforms as a function of time for the prior art circuit of Figs. 3 and 4;

Fig. 8 is a plot of several waveforms as a function of time for the circuit in Figs. 5-7;

Fig. 9 is a detailed schematic diagram of the circuit for practicing the present invention; and

Fig. 10 is a timing diagram related to the circuit of Fig. 9.

### Detailed Description of the Preferred Embodiment

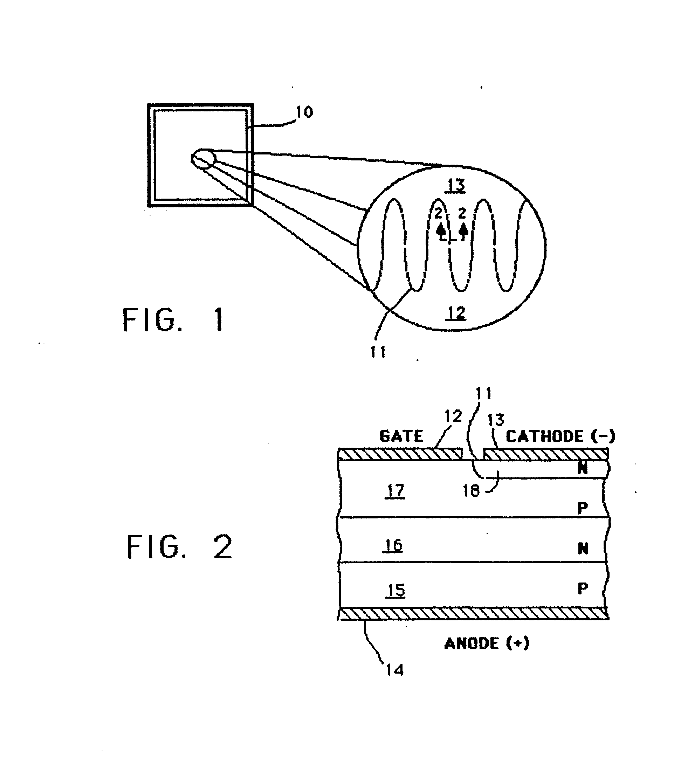

Fig. 1 shows a gated turn-off (GTO) thyristor 10, which is a circuit covering an area of about 1/4 inch by 1/4 inch. With an outer casing removed, a dark serpentine line 11 can be seen on the top of circuit. This line 11 separates and outlines interdigitated fingers 12 and 13, which are formed by a layer of conductive material.

As seen in Fig. 2, the line is a gap where conductive material has been removed to separate the fingers 12 and 13, which form a gate terminal and a cathode (negative terminal), respectively. On the bottom side of the circuit 10 is an anode (positive terminal) layer 14.

Thus, it can be appreciated that the terminals 12-14 of the thyristor 10 cover a substantial area of the device. Thyristors of the type in this example are high power devices with rated voltages up to 1200 volts. Current ratings for these devices are in the range of 70-80 amps for non-repetitive current interruption and around 50 amps for repetitive current interruption. These voltage and current ratings are high in comparison with the ratings of the typical low power semiconductor devices, which may be in the range of 5-20 volts and a fraction of an amp, respectively. The large areas of the anode and cathode are advantageous in handling the operating currents in a high power semiconductor device.

In the thyristor 10 layers of p-type and n-type material are alternated to form a sandwich structure, which is referred to as a p-n-p-n semiconductor device relative to the anode 14. The first layer 15 p-type semiconductive material contacts the anode terminal layer 14. Next up from the bottom is a first layer 16 of n-type semiconductive material, followed by a second layer 17 of p-type semiconductive material which contacts the gate terminal 12. Lastly, regions 18 of n-type semiconductive material are found on top of areas of layer 17, these regions being generally limited to the area of the cathode fingers 13, so that areas of layer 17 are allowed to contact with the gate terminal 12.

-7-

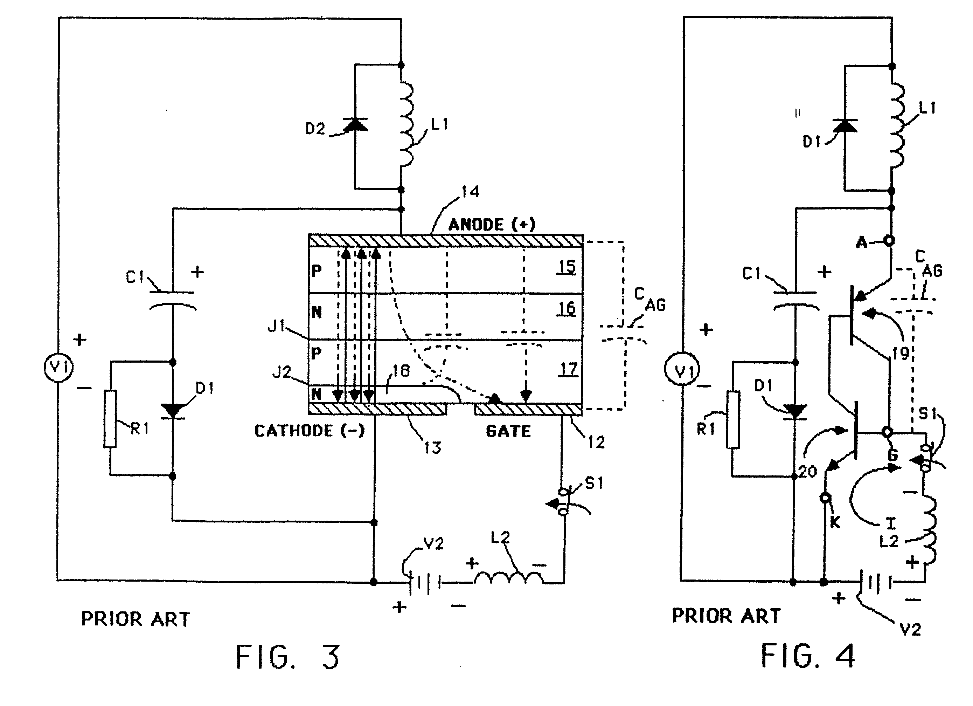

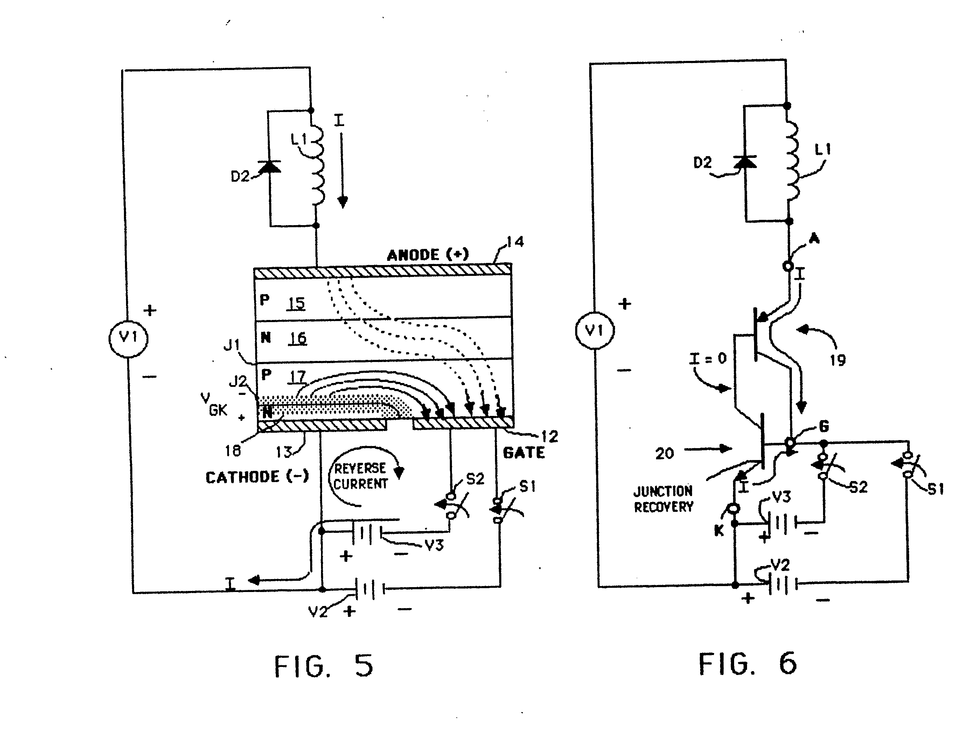

As seen in Figs. 3-6, the sectional area of Fig. 2 has been turned upside down so that the anode 14 is at the top and the cathode 13 is at the bottom, which is the conventional orientation for circuit diagrams. In Figs. 4 and 6, the anode, cathode and gate terminals are identified simply by the initials A, K and G, respectively.

The 4-layer p-n-p-n sandwich that forms the thyristor can also be represented as a p-n-p transistor 19 connected to an n-p-n transistor 20 as seen in Figs. 4 and 6. The top layer 15 of p-type material functions as the emitter of transistor 19. The layer 16 of n-type material functions as the base of transistor 19 and also as the collector of transistor 20. The layer 17 of p-type material functions as the collector of transistor 19 and also as the base of transistor 20. The layer 18 of n-type material functions as the emitter of transistor 20.

Fig. 3 shows a snubber circuit of the prior art connected across the anode 14 and cathode 13 of the thyristor 10. The snubber circuit includes a capacitor C1 with a negative plate connected in series to an anode of a diode D1. A resistor R1 is connected in parallel to the diode D1. A voltage supply V1 is connected across the anode 14 and cathode 13 through a load inductance L1, which may be a motor winding or the like. A diode D2 is connected across such a load L1 to provide a path for dissipation of energy from inductor L1 after thyristor 10 is turned off.

A d-c voltage souce V2 is connected across the gate 12 and cathode 13 and, when switch S1 is closed, it will apply a negative bias voltage to the gate 12 relative to the cathode 13. During steady-state operation the gate 12 is at a positive voltage relative to the cathode 13, so this bias voltage may also be referred to as a "reverse" bias voltage. An inductor L2 of 2 microhenries is connected in series with the voltage source V2 in the path from the gate 14 to the cathode 13, as recommended by the manufacturer of the thyristor 10.

After switch S1 is closed at T=0, some current (the flow of charge carriers) is diverted to the gate 12, while the remaining current begins to crowd away from the gate 12. The solid lines represent the flow of electrons (negative charge carriers), while the dashed lines represent the flow of holes (positive charge carriers) in the opposite direction. The thyristor 10 will attempt to maintain conduction of current in the region near the center of the cathode fingers 13 by increasing its own anode voltage relative to the gate 12. This is a capacitive effect that is represented by phantom capacitor $C_{AG}$. Most of the charge for this capacitor $C_{AG}$ is present at the junction J1 of layers 16 and 17. If the anode-to-gate voltage $V_{AG}$ rises too rapidly it may actually increase current in a concentrated region of flow, leading to failure of the thyristor 10.

The snubber circuit inhibits the rise of $V_{AG}$ by charging capacitor C1. Between turn-off operations the capacitor C1 must be discharged. The resistor R1 provides a discharge path for the capacitor C1 when the thyristor 10 is turned on, while the diode D1 acts to shunt the resistor R1 when the capacitor C1 is charging during a turn-off operation.

While the snubber circuit is limiting the rise of $V_{AG}$, the junction J2 between the layers 17 and 18 exhibits an avalanche effect. In a p-n junction diode, this effect occurs when a negative or reverse voltage is applied to the p-type anode. If the reverse voltage is great enough, the diode will "break down" or "avalanche" to conduct a large current in the direction that it normally blocks the flow of current. When the breakdown point is reached, an increase in applied voltage will increase current without appreciably increasing the voltage drop across the diode. Certain diodes known as Zener diodes are designed to operate as voltage limiters and current shunts. These diodes are associated with a well known voltage-current characteristic in which there is a "knee" at the breakdown point.

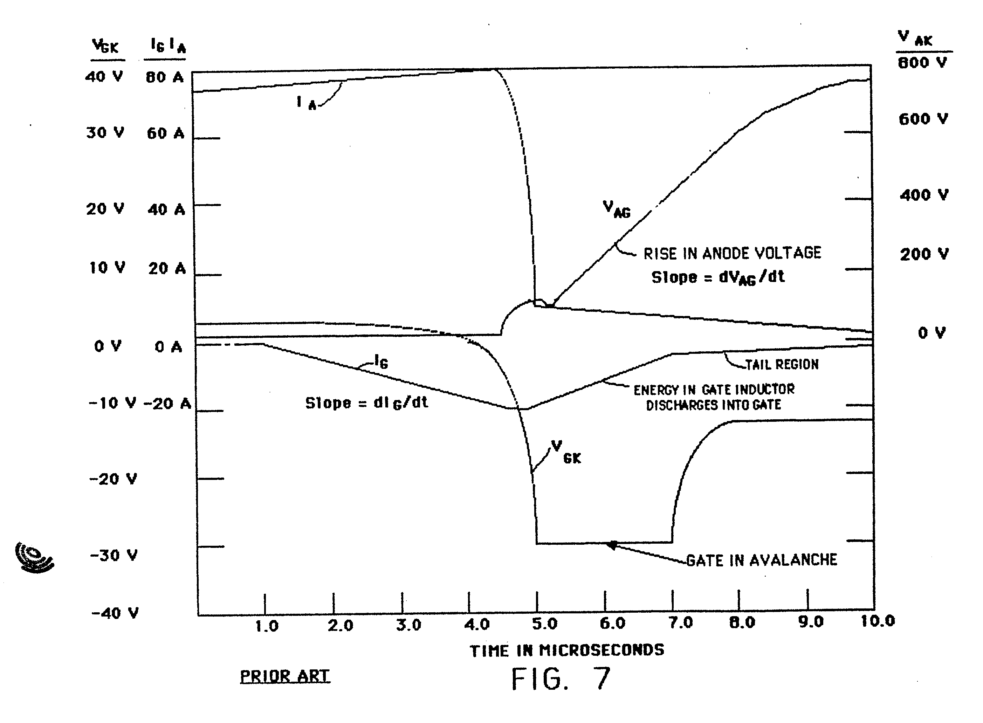

Fig. 7 shows a turn-off event using the circuit of Figs. 3 and 4, and this event will include an avalanche effect. Before turn-off, the voltage from source V1 is 650 d-c volts, the steady-state anode current ($I_A$) is 80 amps, the gate-to-cathode voltage $V_{GK}$ is + 2-3 d-c volts and the gate current ($I_G$) is zero.

When the switch S1 is closed at T=0, a reverse gate-to-cathode voltage of -12 dc volts is applied. This causes the gate-to-cathode voltage $V_{GK}$ to increase in the negative direction due to the blocking of reverse current at the p-n junction J2. As $V_{GK}$ increases, the junction J2 exhibits a recovery in which charge carriers that would allow some reverse current are removed from the junction.

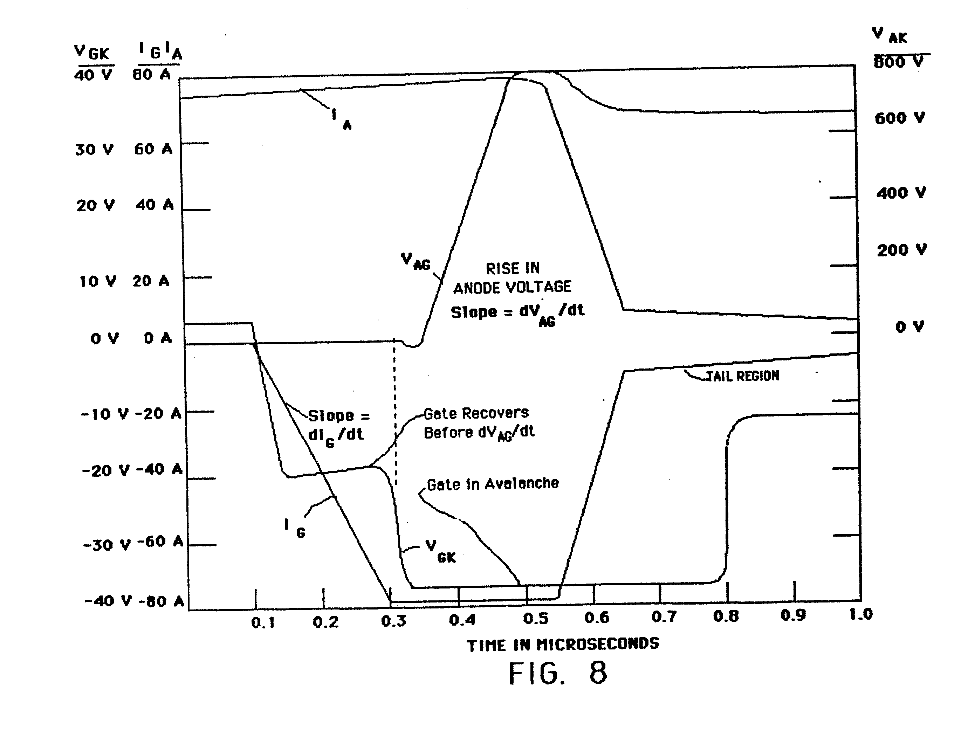

The recovery effect is followed by the avalanche effect, in which the voltage measured across the gate and cathode will remain reasonably steady, although it is now greater (-30 dc volts) than the applied voltage (-12 dc volts). In the period from T+5 microseconds to T+7 microseconds, reverse avalanche current flows to dissipate any energy stored in the gate circuit path in Figs. 3 and 4. This path includes inductor L2 and the internal resistance of the voltage source V2. Inductor L2 stores energy as the flow of $I_G$ increases in the negative direction as shown in Fig. 8 from T+1 microsecond to T+5 microseconds. This energy is dissipated in the period from T+5 microseconds to T+7 microseconds when the magnitude of $I_G$ is gradually subsiding from its peak negative value. When this energy has been dissipated at T+7 microseconds, the gate-to-cathode voltage ($V_{GK}$) begins to decrease.

The problem in Fig. 7 is that before the recovery of the junction and before the beginning of the avalanche effect, a substantial rise in the anode-to-gate voltage relative to time ($dV_{AG}/dt$) has occurred. To prevent the type of device failure discussed earlier, the snubber circuit must be employed to limit this rise.

The method of the invention is illustrated schematically in Figs. 5 and 6 in which the snubber circuit has been removed. The inductor L2 has also been removed. A voltage source V3 is connected across the gate 12 and cathode 13 in parallel to the voltage source V2. This voltage source V3 is connected in series with switch S2 to control the application of voltage across the gate 12 and cathode 13.

The purpose of this circuit is to generate a maximum change in gate current with respect to time ($dI_G/dt$) by maximizing reverse bias voltage (V) and minimizing the inductance ($L_G$) in the gate circuit in the following expression:

$$\frac{V}{L_G} = dI_G/dt \qquad (1)$$

The avalanche voltage of most commercially available GTO's is below 20 volts, and while inductor L2 can be removed, the maximum $dI_G/dt$ that would normally be expected would be on the order of 100 amps/microsecond.

Underlying the invention is the discovery that a greater magnitude of $dI_G/dt$ can be obtained over a short period of time by applying a voltage that is greater than the avalanche voltage, without damaging the thyristor 10. In Figs. 5 and 6 a voltage of -100 dc volts is applied across the gate and cathode by closing switch S2 at T=0. This voltage supersedes the -12-volt voltage until switch S2 is opened. To minimize $L_G$, the inductor L2 has been removed.

The large reverse gate-to-cathode bias voltage is applied for sufficient time to cause the junction recovery effect, and it has been discovered that this will occur before the capacitive effect involving the rise of anode-to-gate voltage relative to time ($dV_{AG}/dt$) occurs. The circuit will also absorb any current due to the capacitive effect. The large reverse voltage is then removed (by opening switch S2) before undue heating occurs at the junction J2 between layers 17 and 18.

Fig. 5 shows the junction recovery effect in which charge carriers at junction J2 are removed, and all of the hole current from the anode is pulled to the gate. As seen in Fig. 6, this is the equivalent of having current I flowing through the PNP transistor 19 and having current from the base of transistor 19 to the collector of transistor 20 cut off (I = 0). This junction recovery effect is later followed by the avalanche effect at junction J2.

In Fig. 8, which illustrates the behavior of the circuit of the invention during a turn-off cycle, it should be noted that the signals are generated over only 1 microsecond, whereas the events in Fig. 7 occur over 10 microseconds. The initial conditions are the same as in Fig. 7, i.e. the voltage from source V1 is 650 d-c volts, the steady-state anode current ($I_A$) is 80 amps, the gate-to-cathode voltage $V_{GK}$ is +2-3 d-c volts and the gate current $I_G$) is zero.

At T=0, switch S1 is closed and a reverse gate-to-cathode voltage of -12 dc volts is applied. At T=0, switch S2 is also closed to apply a reverse gate-to-cathode voltage of -100 dc volts. As seen in Fig. 8, $I_G$ increases to -80 amps in just 0.2 microseconds to produce a $dI_G/dt$ of 400 amps/microsecond. From T+0.1 microseconds to T+0.3 microseconds, the applied voltage is divided between the internal impedance of the voltage source V2 and the internal impedance of the thyristor 10 to produce the gate-to-cathode voltage $V_{GK}$ seen in Fig. 8. In that period the pause at -20 dc volts and the subsequent increase to -40 dc volts shows that the junction J2 has recovered. This is an indication that the gate-to-cathode region has been turned off.

Shortly after T+0.3 microseconds, the $V_{GK}$ is near -40 dc volts, which is a combination of the avalanche voltage (about -30 dc volts) and the IR voltage drop in the gate circuit due to gate circuit current and the internal resistance of the thyristor 10. From 0.35 microseconds to 0.5 microseconds capacitive current due to $dV_{AG}/dt$ is drained from the device.

Several notes should be made about the timing of these events. First, the gate turn-off indication precedes the rise of anode-to-gate voltage relative to time ($dV_{AG}/dt$). This means that the snubber circuit is no longer necessary. Second, there is still some capacitive charge at the junction J2 of layers 17 and 18 and as this drains off, $I_A$ and $I_G$ remain for a period at +80 amps and -80 amps, respectively, and then drop down to 10 amps at T+0.65 microseconds. Third, after this charge has drained off, the gate-to-cathode

-13-

voltage ($V_{GK}$) drops back to the voltage of -12 volts. This voltage will hold the device in the off state and allow residual currents $I_A$ and $I_G$ to gradually approach zero over a "tail period" beginning at T+0.65 microseconds. At this point it can be said that the anode current flowing into the device before turn-off has been substantially interrupted.

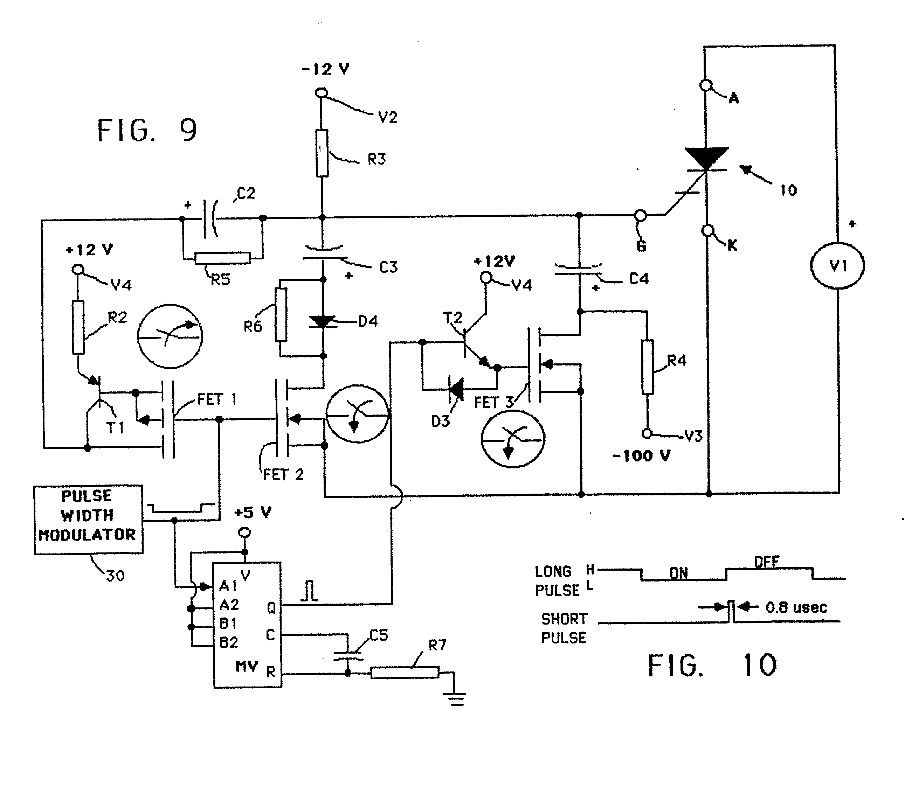

A driver circuit for practicing the invention is shown in detail in Fig. 9. In the circuit there are three MOSFET transistors FET 1, FET 2 and FET 3. FET 1 is a p-type MOSFET available under P/N VP0204N5 From Siliconix, Inc. of Santa Clara, California. When FET 1 is turned on, it turns on PNP transistor T1. A voltage of +12 volts is supplied from source V4 to the emitter of the transistor T1 through resistor R2, and when transistor T1 is on, current flows through its collector to capacitor C2. Capacitor C2 charges up to +12 dc volts, first allowing full current flow, and later diminishing current as capacitor C2 becomes fully charged. Resistor R5 is connected across capacitor C2 to provide a discharge path. The initial current flow will flow into the gate (G) of the thyristor 10 and will cause it to turn on. Thus, FET 1 is similar to a switch that is closed to apply +12 dc volts to the gate (G) to turn on the thyristor 10.

FET 2 is analagous to switch S1 in Figs. 3-6. When FET 2 is turned on, the -12 volt supply V2 causes current to flow through resistor R3 and R6 to charge capacitor C3. FET 2 is a specific example of switch S1 that is closed to apply -12 dc volts to the gate (G) of the thyristor 10. FET 2 is an n-type MOSFET available under P/N BUZ71A from Motorola Semiconductor, Inc. of Phoenix, Arizona.

-14-

FET 3 is analagous to switch S2 in Figs. 5-6. When FET 3 is turned off, the -100 volt supply V3 causes current to flow through resistor R4 to charge capacitor C4. When FET 3 is turned on, the discharge of the capacitor C4 will drain current from the gate (G) of the thyristor 10 to assist in turning it off. Thus, FET 3 is a specific example of switch S2 that is closed to apply -100 dc volts to the gate (G) of the thyristor 10. FET 3 is an n-type MOSFET available under P/N IRF640 from International Rectifier Corporation of El Segundo, California.

Other circuitry is shown in Fig. 9 for controlling the periods in which the FET's are on and off. A pulse width modulator 30 includes a comparator (not shown) that receives a ramp input at one terminal and compares it to a d-c level at another input to control the width of an output pulse, referred to as a LONG PULSE. In this example, the output of the pulse width modulator 30 is connected to the gates of FET 1 and FET 2. A logic low portion of the LONG PULSE will turn on FET 1 and turn off FET 2, and such a signal is used to turn on the thyristor 10 as indicated by the term "ON" in Fig. 10. A logic high signal will turn off FET 1 and turn on FET 2 which is represented by the switching symbols circled in Fig. 9. The width of the logic high signal will define a turn off period for the thyristor 10 as indicated by the term "OFF" in Fig. 10.

FET 3 is turned on and off in response to a SHORT PULSE coupled from the Q output of a multivibrator MV to the base of an NPN transistor T2. The transistor T2 has its collector connected to the +12-volt source V4, and when a positive voltage is applied across its base-emitter junction, transistor T2 will turn on to supply current to the gate of FET 3. This turns on FET 3 to apply -100 dc volts to the gate (G) of the thyristor 10. The SHORT PULSE is 0.8 microsecond in duration, which corresponds to the period of application of -100 volts in relation to Fig. 8. This is long enough to accomplish the turn-off without causing undue heating within the thyristor 10.

When the SHORT PULSE is completed as shown in Fig. 10, the signal to the base of transistor T2 in Fig. 9 goes low, and transistor T2 and FET 3 are switched off. The diode D3 has an anode connected to the emitter of T2 and its cathode connected to the base of T2. The diode D3 helps pull the base to ground potential. After FET 3 is switched off, FET 2 will remain on until the next transition of the LONG PULSE.

A diode D4 is connected in series with FET 2, so that when FET 2 and FET 3 are both on, current will not flow from the -100-volt source to charge capacitor C3. Resistor R6 is connected across diode D4 to provide a discharge path for current from capacitor C3.

The multivibrator MV receives the LONG PULSE at its A1 input. The A2, B1 and B2 inputs are pulled up to +5 volts to place the multivibrator in a one-shot timing mode of operation. When the LONG PULSE is low, the Q output of multivibrator MV is reset to a logic low signal. When the LONG PULSE goes high, the signal from the Q output is switched high until the circuit times out, and then automatically switches back to the logic low state to define the SHORT PULSE. The timing period is controlled by capacitor C5 and resistor R7 connected to C and R inputs on the multivibrator MV. The values of these components are chosen according to the specifications of the manufacturer of the multivibrator MV to provide a timing period of 0.8 microseconds. A 74122 multivibrator circuit available from Fairchild Camera and Instruments Co., Mountain View, California, is suitable for use as multivibrator circuit MV. This completes the description of the detailed circuit of Fig. 9.

This description has covered the method of the invention, as well as a detailed circuit for carrying out the invention. Those skilled in the art will recognize that many of the details of this description may be modified without departing from the basics of the invention. Therefore, to distinguish that which has been given by way of example from that which is basic to the invention, the following claims have been made.

0243844

1.  A method of turning off a gate turn-off thyristor, the method comprising:

applying across a gate and a cathode of the thyristor a reverse bias voltage that is greater than an avalanche voltage across a gate-cathode junction;

maintaining the reverse bias voltage until a capacitive effect across the anode and gate of the thyristor has subsided; and

removing the reverse bias voltage in sufficient time to prevent undue heating within the thyristor.

2. The method of claim 1, further comprising the step of connecting a power supply circuit for applying the reverse bias voltage to the gate of the thyristor through a circuit path that is free of inductive devices.

3. The method of claim 1, further comprising the step of applying across the gate and a cathode of the thyristor a second reverse bias voltage that is less than the avalanche voltage across the gate and cathode, wherein the second reverse bias voltage is superseded during the time that the greater-than-avalanche voltage is applied.

-19-

4. A method of turning off a gate turn-off thyristor that is conducting its rated current, the method comprising:

applying across a gate and a cathode of the thyristor a reverse bias voltage that is greater than an avalanche voltage across a gate-cathode junction;

maintaining the reverse bias voltage until gate current generated by a recovery effect across the gate-cathode junction has subsided; and

removing the reverse bias voltage in sufficient time to present undue heating within the thyristor.

5. The method of claim 4, further comprising the step of connecting a power supply circuit for applying the reverse bias voltage to the gate of the thyristor through a circuit path that is free of inductive devices.

6.    A circuit for turning off a gate turn-off thyristor, the circuit comprising:

means for applying across a gate and a cathode of the thyristor a reverse bias voltage that is greater than the avalanche voltage across a gate-cathode junction; and

means for controlling the means for applying the reverse bias voltage to maintain the reverse bias voltage until the anode current has been substantially interrupted; and

wherein the means for controlling includes means for removing the reverse bias voltage in sufficient time to prevent undue heating within the device.

7. The circuit of claim 6 wherein the means for applying the reverse bias voltage is connected to the gate of the thyristor through a circuit path that is free of inductive devices.

8. The circuit of claim 6, further comprising means for applying across the gate and a cathode of the thyristor a reverse bias voltage that is less than the avalanche voltage across the gate-cathode junction.

FIG. 1

FIG. 2

PRIOR ART    FIG. 4

PRIOR ART    FIG. 3

0243844

FIG. 6

FIG. 5

FIG. 7

PRIOR ART

FIG. 8

FIG. 9

FIG. 10

0243844